# EUROPEAN PATENT SPECIFICATION

(11) **EP 1 425 718 B1**
(45) Date of publication and mention of the grant of the patent: **12.01.2011**
(21) Application number: 02757533.1
(22) Date of filing: 30.08.2002
(51) Int. Cl.: G06T 17/10

(54) **SIMULTANEOUS USE OF 2D AND 3D MODELING DATA**
GLEICHZEITIGE BENUTZUNG VON 2D- UND 3D-MODELLIERUNGSDATEN
UTILISATION SIMULTANEE DE DONNEES DE MODELISATION BIDIMENSIONNELLES ET TRIDIMENSIONNELLES

(30) Priority: 31.08.2001 US 316750 P
(43) Date of publication of application: 09.06.2004
(73) Proprietor: Dassault Systemes SolidWorks Corporation, Concord MA 01742 (US)
(72) Inventor: SHOOV, Boris, Nashua, NH 03063 (US); KEKLAK, John, Sudbury, MA 01776 (US); ZUFFANTE, Robert, Concord, MA 01742 (US)
(74) Representative: Hirsch & Associés
(86) International application number: PCT/US2002/027840
(87) International publication number: WO 2003/021394

(56) References cited:
- US-A- 5 590 062
- US-A- 5 682 468
- US-A- 5 701 403
- US-A- 5 821 941
- US-A- 5 850 352
- US-B1- 6 222 551
- US-B1- 6 434 277
- BYEONG-SEOK SHIN ET AL: "Fast 3D solid model reconstruction from orthographic views" COMPUTER AIDED DESIGN ELSEVIER UK, vol. 30, no. 1, January 1998 (1998-01), pages 63-76, XP004112170 ISSN: 0010-4485
- SHUM S S P ET AL: "Solid reconstruction from orthographic opaque views using incremental extrusion" COMPUTERS AND GRAPHICS, PERGAMON PRESS LTD. OXFORD, GB, vol. 21, no. 6, 12 November 1997 (1997-11-12), pages 787-800, XP004106909 ISSN: 0097-8493

## Description

### BACKGROUND OF THE INVENTION

Computer-aided design (CAD) software allows an engineer to construct and manipulate complex three-dimensional (3D) models of assembly designs. A number of different modeling techniques can be used to create a model of an assembly. These techniques include solid modeling, wire-frame modeling, and surface modeling. Solid modeling techniques provide for a topology of a 3D model, whereby the 3D model is a collection of interconnected edges and faces. Geometrically, a 3D solid model is a collection of trimmed surfaces, where the surfaces correspond to the topological faces bounded by the edges. Wire-frame modeling techniques, on the other hand, can be used to represent a model as a collection of simple 3D lines, whereas surface modeling techniques can be used to represent a collection of exterior surfaces. CAD systems may combine these techniques with other modeling techniques, such as parametric modeling. Parametric modeling techniques can be used to define various parameters for different components of a model, and to define relationships between various parameters. Solid modeling and parametric modeling can be combined in CAD systems supporting parametric solid modeling.

In addition to supporting 3D objects, CAD systems can support two-dimensional (2D) objects (which can be 2D representations of a 3D object). Two- and three-dimensional objects are useful during different stages of a design process. Three-dimensional representations of a model are commonly used to visualize a model in a physical context because the designer can manipulate the model in three-dimensional space and can visualize the model from any conceivable viewpoint. Two-dimensional representations of the model are commonly used to prepare and formally document the design of a model. However, some commercially available CAD systems only support 2D representations. In this situation, users may be able to mentally visualize 3D representations in three-dimensional space, even though the user is working in a 2D environment.

In 3D systems, some tasks are easier to perform using 2D representation of a model instead of by directly manipulating a 3D representations of a model. For example, specifying critical dimensions may be easier using a 2D representation. Understanding complex geometries may also be easier using a 2D representation because the 2D representation may be a simplified image of a 3D model.

In the engineering field, CAD systems may provide for orthographic 2D views of the left, right, top, bottom, front, and back sides of a model, in addition to auxiliary views. These CAD systems may display more than one view of the model simultaneously on the system's display, with each view of the model appearing in a separate window. For example, a CAD system may display the left, right, top, and bottom views of a model, each view displayed simultaneously in a separate window. Alternatively, the views may be arranged in the same window. To determine how objects in one 2D view physically relate to the same object or a different object in another 2D view, the engineer may need to analyze the 2D views, discover where objects in one view connect to objects in another view, and mentally construct a 3D model. Often, the engineer has difficulty relating one view to another and visualizing the 3D model.

For a clear understanding of the relationship between a 3D object and 2D representations of the 3D object, engineering students are often taught the concept of a "glass box." First, the student is instructed to visualize the 3D object inside a glass box. The student is then taught to imagine that on each side of the glass box is a view of the 3D object projected outward onto the side of the glass box. Thus, on each side of the glass box is a 2D representation of the 3D object, and in particular, six orthogonal 2D views of the 3D object corresponding to the left, right, bottom, top, front, and back side of the glass box. The students are then instructed to visualize the six sides of the glass box unfolding until all sides of the box lie in the same plane, as though someone were neatly unwrapping a piece of paper covering the outside of the glass box. After the sides are unfolded, one plane contains all six orthogonal views and is a 2D representation of the 3D object.

In addition to visualizing a 3D model in two-dimensional space, an engineer may wish to visualize a 2D representation in three-dimensional space or convert a 2D representation into a 3D model. Some state-of-the-art 3D CAD systems provide a means to import data that was generated by a 2D system. After importing the 2D data, the 2D data needs to be converted to 3D model data. In general, only rudimentary tools are provided to assist in converting 2D data into a 3D model and, in many cases, a manual process is used to convert 2D data to 3D model data. Typically, this manual process requires significant user interaction in order to define the spatial relationships between different 2D views of a model.

Generally, CAD systems that support conversion of 2D data to a 3D model require the user to perform a series of manual tasks to convert 2D data to 3D data. The task of converting a 2D representation to a 3D model may involve a tedious manual process for positioning imported planar 2D data into 3D space. This process may require a number of time-consuming steps, where each step is subject to user or system errors. These errors may be due to the manual nature of defining the spatial relationships between the different viewing planes and the geometry placed on those planes. Manually creating these planes and positioning the geometry on the planes can be a difficult process requiring a high-comfort level with 3D orientations and visualization. Furthermore, many engineers who convert 2D representations into 3D models may not be familiar with and may not be comfortable using a 3D CAD system. Additionally, in some cases, the complexity of the 2D to 3D conversion process is increased because the full collection of tools required for the task are not available within a single software package.

Document US-A-5 701 403 discloses a CAD system which has a correspondence between predetermined drawing regulations and three-dimensional objects and a section for building a three-dimensional product model on the basis of a two-dimensional drawing, which is created under one of the predetermined drawing regulations, by reference to the correspondence. The building section can reconstruct a product model by reference to an attribute added to a view.

Document Byeong-Seok Shin et al. "Fast 3D Solid Model Reconstruction From Orthographic Views", Computer Aided Design, January 1998, pages 63-76, XP004112170 describes a 3D model reconstruction algorithm which reduces the number of examination by using the relationship between 2D information in each view and the 3D information generated during the reconstruction process.

Some CAD systems provide automated methods for converting 2D data to 3D data. However, many automated tools only work for a small percentage of models due to accuracy and reliability problems. Automated calculations that covert 2D data to 3D data may introduce significant errors when handling complex mappings. For example, 2D views may not be positioned correctly in 3D space and may not be positioned correctly with respect to one another when the 2D views represent a non-prismatic 3D model. Furthermore, invalid data conditions may arise, such as overlapping geometry and gaps being introduced where geometry should meet. A large part of the accuracy problems are due to the fact that the geometry of a 2D drawing is less important to the engineer creating the drawing than the annotations in the drawing, (which is why many drawings contain instructions not to measure the drawings).

Due to the difficulty in manually converting 2D data to 3D data with existing tools, and the accuracy and reliability problems of a fully automated approach, 2D to 3D conversion services are being introduced in the market. Rather than expending in-house resources to perform what may be a difficult process, an engineering enterprise may use a conversion service when design engineers decide to shift their models from a 2D software application to a 3D software application. Two-dimensional to three-dimensional conversion services are provided by a number of commercial businesses.

A mechanism that enables a user to work with 2D and 3D representations of a model simultaneously can help solve the existing problems of interpreting and visualizing planar 2D drawings as 3D objects and vice versa, performing drawing and modeling operations with the aid of both 2D and 3D representations, and constructing 3D models from 2D data.

### SUMMARY OF THE INVENTION

Mapping between a 2D and a 3D representation of the model is often a difficult process, particularly where complex assembly structures are involved. To facilitate this conversion, tools that allow a user to view and relate 2D and 3D representations of a model in an interactive window are desired. Such tools may improve a user's understanding of associations between the 3D model and the 2D representations of the 3D model.

Systems and methods for automating the conversion between data representing a 2D projections and a 3D model are disclosed herein. In some implementations, these systems and methods can reduce or remove difficulties involved in using existing tools to convert 2D data to 3D data. In one aspect, the invention features systems and methods implementing a semi-automatic conversion approach. This conversion approach may include automated 2D to 3D spatial positioning and spatial folding guided through user interaction with the modeling system. Implementations may also provided an automated mechanism for the creation of 3D solid models in which an engineer has an interactive role in the conversion process. The interaction with the engineer can improve conversion of the 2D data into 3D space by allowing the engineer's preferences and perspectives to be considered in the conversion process. Additionally, user control of the creation and accuracy of the conversion between 2D and 3D models provides users with an interactive learning tool enabling users to intervene in the model building process. Implementations can include software to assist a 3D CAD system user in understanding and manipulating 3D spatial relations implicated in the mapping between 2D to 3D data.

The details of one or more embodiments of the invention are set forth in the accompanying drawings and the description below. Implementations can provide tools reducing or simplifying the steps needed to convert between 2D and 3D representations of an object. Other features, objects, and advantages of the invention will be apparent from the description and drawings, and from the claims.

### DESCRIPTION OF THE DRAWINGS

FIG. 1 is a diagram of a computer system.
FIG. 2 is an illustration of a 3D model displayed on a CRT.
FIG. 3 is an illustration of a 2D drawing.
FIG. 4 is an illustration depicting user interaction for a conventional 3D modeling system.
FIG. 5 is an illustration depicting user interaction with a modeling system that incorporates the present invention.
FIG. 6A is an illustration of a virtual glass box in a folded state.
FIG. 6B is an illustration of a virtual glass box in an unfolded state.
FIG. 7 is a flowchart of a process that projects the 3D model onto the sides of the virtual glass box.
FIG. 8 is a illustration of a toolbar.
FIG. 9 is a flowchart of a folding process.
FIGS. 10a and 10b are illustrations of four views mapped to the sides of a virtual glass box.
FIG. 11 is an illustration of a 3D model and 2D projections of the 3D model.

### DETAILED DESCRIPTION OF THE INVENTION

The present invention improves the functionality of computer-aided design (CAD) systems by enabling a CAD system user (typically an engineer) to work with 2D and 3D representations of a model without have to switch between a 2D and a 3D application environment. Improvements may be achieved by simultaneously displaying 2D and 3D representations on a CAD system output display and allowing a CAD user to interact with either the 2D or 3D representation. The user may direct the CAD system to perform 3D functions using a 2D representation of the model and to perform 2D functions using a 3D representation of the model. Additionally, the present invention aids the user in converting between, and understanding the relationships between, 2D and 3D representations of a modeled object. The CAD system can also employ display techniques such as animation to fold a 2D representation into a 3D model and to unfold the 3D model into a 2D representation to enable further understanding of the relationships between 2D and 3D representations of a 3D model defined and displayed by a computerized modeling system.

The present invention automates the conversion process between 2D and 3D representations of a model such that a user unfamiliar with 3D applications can work with both 2D and 3D data before getting fully comfortable with 3D spatial relations. An automatic folding process utilized by the present invention eases the transition from working with 2D representations to working with 3D models, in addition to eliminating a barrier that prevents 2D users from changing to a more efficient 3D CAD system. The automatic 2D to 3D folding process also helps users become more comfortable with working in three-dimensional space by teaching the users how a 2D representation maps into a 3D model and vice versa.

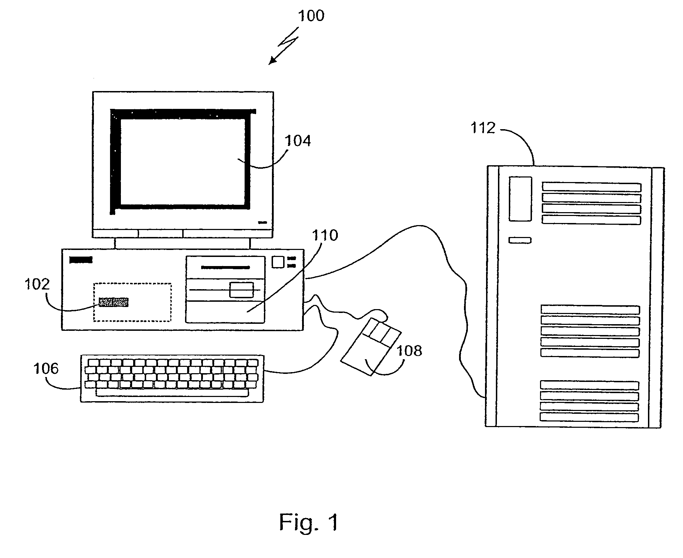

FIG. 1 shows a computerized modeling system 100 that includes a CPU 102, a CRT 104, a keyboard input device 106, a mouse input device 108, and a storage device 110. The CPU 102, CRT 104, keyboard 106, mouse 108, and storage device 110 can include commonly available computer hardware devices. For example, the CPU 102 can include a Pentium-based processor. The mouse 108 may have conventional left and right buttons that the user may press to issue a command to a software program being executed by the CPU 102. Other appropriate computer hardware platforms are suitable as will become apparent from the discussion that follows. Such computer hardware platforms are preferably capable of operating the Microsoft Windows NT, Windows 95, Windows 98, Windows 2000, Windows XP, Windows ME, or UNIX operating systems.

Computer-aided design software is stored on the storage device 110 and is loaded into and executed by the CPU 102. The software allows a design engineer to create and modify a 2D or 3D model and implements aspects of the invention described herein. The CPU 102 uses the CRT 104 to display a 3D model and other aspects thereof as described later in more detail. Using the keyboard 106 and the mouse 108, a design engineer can enter and modify data for the 3D model. The CPU 102 accepts and processes input from the keyboard 106 and mouse 108. The CPU 102 processes the input along with the data associated with the 3D model and makes corresponding and appropriate changes to that which is displayed on the CRT 104 as commanded by the modeling software. Additional hardware devices may be included in the computerized modeling system 100, such as video and printer devices. Furthermore, the computerized modeling system 100 may include network hardware and software thereby enabling communication to a hardware platform 112.

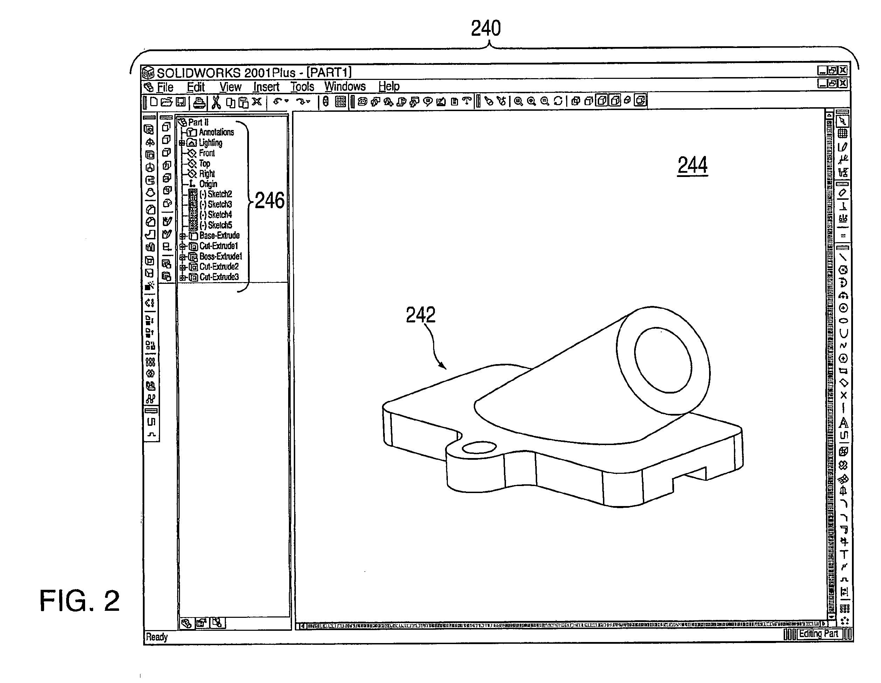

Referring now to FIG. 2, an image on the CRT 104 is shown in detail and includes a window 240. The window 240 is a conventional computer-generated window that can be programmed by one of ordinary skill in the art using conventional, commercially available, software programming tools, such as those available from Microsoft Corporation of Redmond, Washington.

A computer-generated 3D model 242 is displayed within a modeling portion 244 of the window 240. A design engineer can construct and modify the 3D model 242 in a conventional manner. The surfaces of the 3D model may be rendered to give the 3D model the appearance of a solid object. Additionally, the 3D model 242 can be displayed using solid lines and dashed lines to show visible edges and hidden edges, respectively, of the 3D model. Implementations also may include other window areas, such as a feature manager design tree 246. The feature manager design tree 246 aids in visualization and manipulation of the model 242 shown in the modeling portion 244.

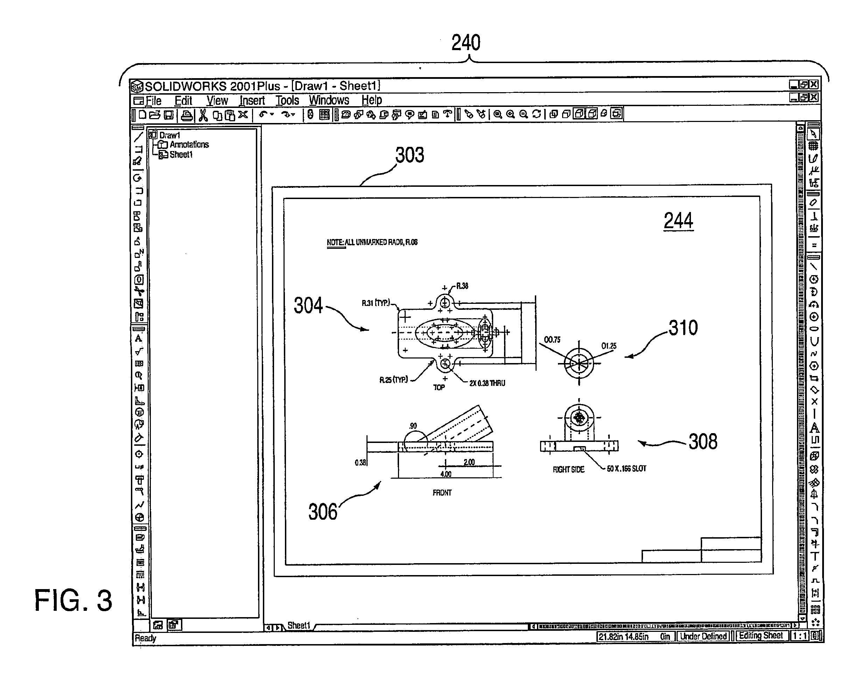

As shown in FIG. 3, in addition to a 3D model 242, the modeling portion 244 may also display a drawing area 303, which contains 2D representations of the 3D model 242. The 2D representations may include a top view 304, a right view 308, a front view 306, and an auxiliary view 310 of the 3D model 242. The 2D representations may be generated from imported 2D data. Alternatively, a 3D modeling system may generate 2D representations from a 3D model, conceivably for the purpose of preparing a formal engineering drawing.

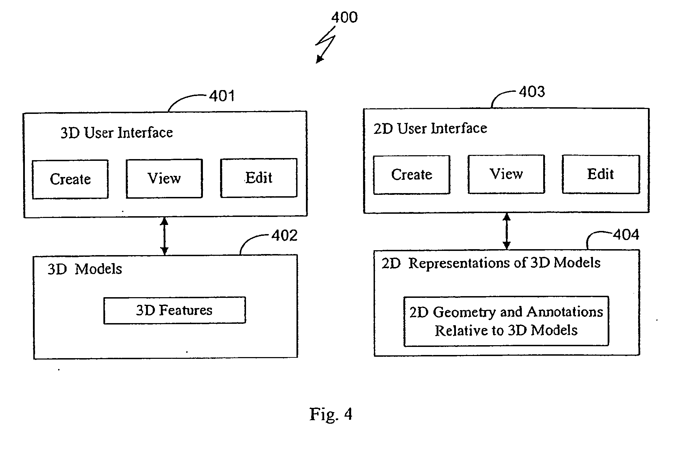

Referring to FIG. 4, an illustration of user interaction for a conventional 3D modeling system 400 is shown. The conventional 3D modeling system 400 enables a CAD user to interact with 3D models 402 or interact with 2D representations of 3D models 404. The user may interact with the 3D models 402 by choosing to create, view, and/or edit 3D features and models via the 3D user interface 401. Alternatively, the user may choose to create, view, and/or edit 2D representations of one or more 3D models 404 (e.g., 2D geometry and annotations relative to a 3D model) via the 2D user interface 403.

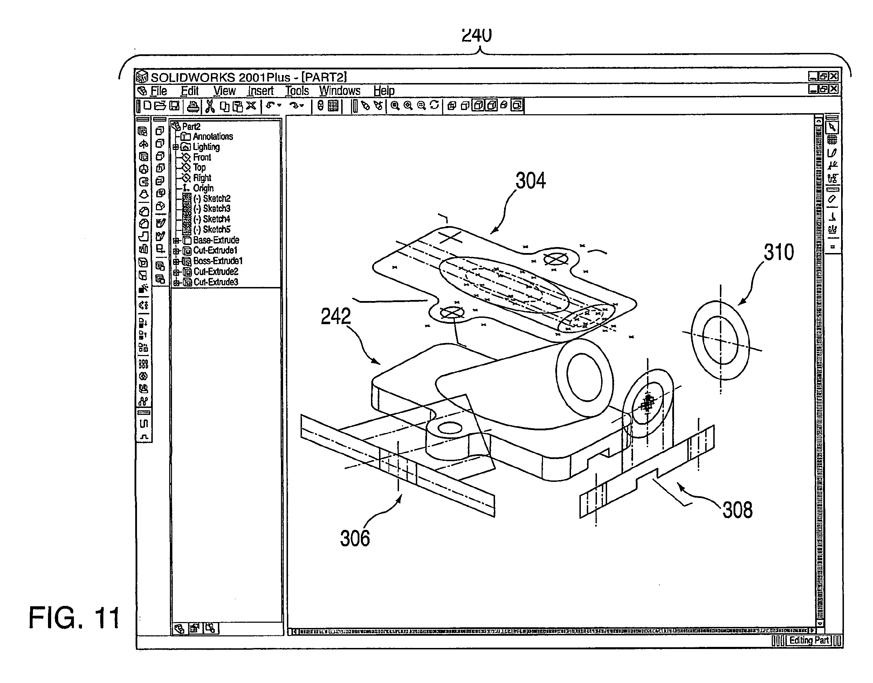

The present invention generates a virtual glass box representation of a model. Unlike a conventional 3D modeling system, the virtual glass box combines 2D and 3D representations of a model in one view, and enables an engineer to interact with the view. The view simultaneously displays a 3D model and one or more 2D projections of the model, in addition to maintaining a relationship between the views at all times. (See FIG. 11 which illustrates a 3D model and 2D projections of the 3D model and later will be discussed.) Furthermore, the virtual glass box allows all 2D drawing operations to be preformed in three dimensions.

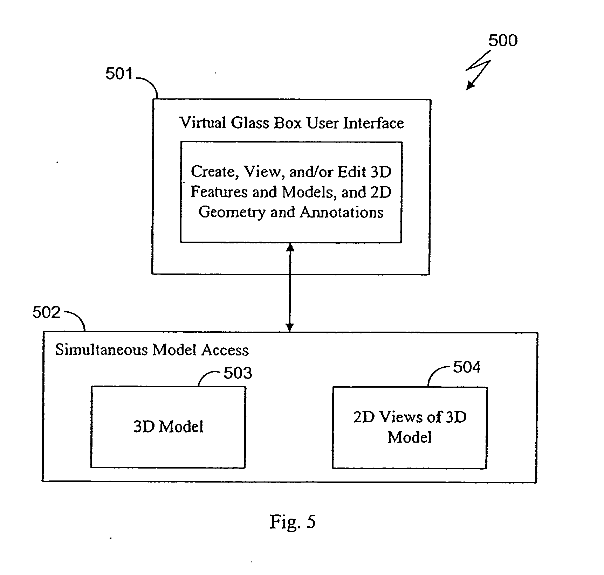

Referring to FIG. 5, the user interaction with a modeling system 500 that incorporates the present invention enables a CAD user to interact with a 3D model 503 and the 2D views of the 3D model 504 simultaneously. The user does not have to select the projection (i.e., 2D or 3D) with which to interact. Rather, the user can create, view, and/or edit the 3D features and models while simultaneously interacting with 2D geometry and annotations using the virtual glass box user interface 501. In an implementation of the present invention, when a 3D representation and a 2D representation are displayed simultaneously, interactions with or modification of either representation may be reflected in the other representation. When the 3D representation is modified, the 2D representations are updated by projecting the 3D representations again onto the sides of the virtual glass box. When a 2D geometric entity in the 2D representation is modified and the 2D entity has a parametric relationship with a feature in the 3D model (such as the case with sketch entities), the 3D model is updated. Thus, the operations are bi-directional and associative with respect to the two representations.

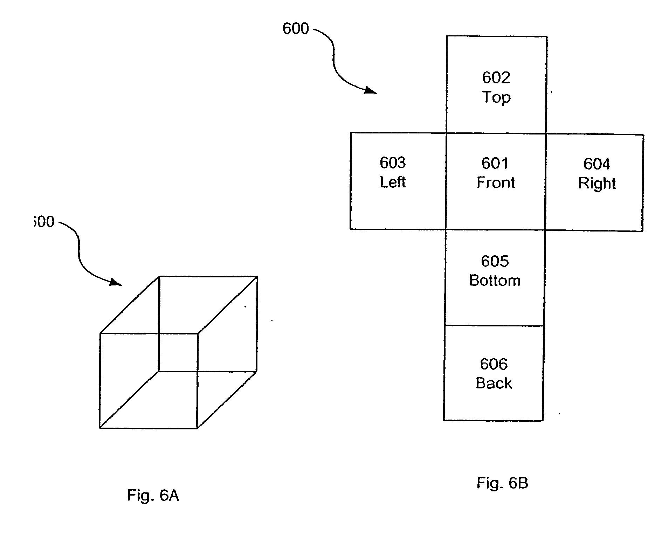

Referring now to FIG. 6A, a rectangular parallelepiped glass box 600 in a folded state is shown. A 3D model may reside within the interior of the virtual glass box 600. Two-dimensional views of the 3D model may be projected onto the sides of the virtual glass box 600 thereby creating up to six 2D views that depict the left, right, bottom, top, front, and back sides of the 3D model. Those skilled in the art understand how to project a 3D model onto a plane in three-dimensional space.

Referring now to FIG. 6B, the virtual glass box 600 in an unfolded state is shown. In FIG. 6B, the virtual glass box 600 is unfolded onto a plane that is coincident with the front of the virtual glass box 600 shown in FIG. 6A. To unfold the virtual glass box 600, each side of the virtual glass box 600 is rotated 90° or -90°. For each side, the 90° or -90° rotation is about an axis coincident to the side's edge that will remain connected to another side of the virtual glass box 600. The center of the rotation lies on the edge that is coincident to the axis of rotation.

To further explain, in FIG. 6B, the left side 603 is rotated 90° about an axis coincident to the edge that remains connected to the front side 601. The right side 604 is rotated -90° about the edge that remains connected to the front side 601. The top side 602 is rotated 90° about an axis coincident to the edge that remains connected to the top of the front side 601. The bottom side 605 is rotated -90° about an axis coincident to the edge connected to the bottom of front side 601. The back side 606 is rotated -90° about the edge shown connected to the bottom side 605 for a total rotation of -180° due to the effect of the -90° rotation applied to the bottom side 605.

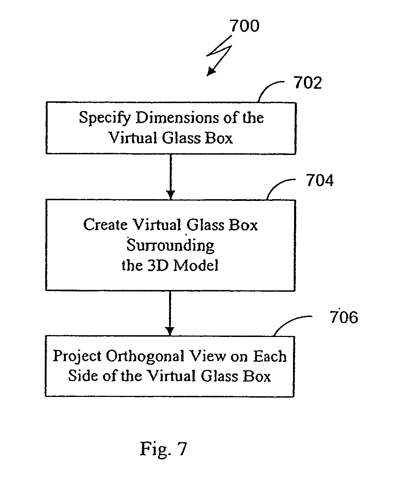

Referring to FIG. 7, a flow chart illustrates steps performed to project a 3D model onto the sides of a virtual glass box. First, the dimensions of the virtual glass box are specified (step 702). The modeling system may have default values to specify the dimensions, may automatically calculate the size of the 3D model and add an offset amount to determine the values for the dimensions of the virtual glass box, or may allow the user to enter values for the dimensions of the virtual glass box. Additionally, the modeling system may display a rectangular parallelepiped virtual glass box and allow the user to use the mouse to move the edges and/or corners of the rectangular parallelepiped until the user is satisfied with the dimensions.

Alternative methods exist to specify the dimensions of the virtual glass box. For example, a user may specify X, Y, and Z axes, the center of which is the center of the virtual glass box. The sides of the virtual glass box are normal to one of the axes and offset by a distance specified by the user.

After the dimensions of the virtual glass box are specified, the modeling system creates the virtual glass box surrounding the 3D model (step 704). The virtual glass box may be a rectangular parallelepiped, in which case, up to six orthographic views of the 3D model may be projected onto each side of the virtual glass box (step 706), (e.g., one view per side of the rectangular parallelepiped) or, for a simpler image, only a top, right and front view. Alternatively, the user may specify which of the orthographic views to project on a side of the virtual glass box.

The virtual glass box may also take the form of other shapes in addition to a rectangular parallelepiped. A use interface may provide a user with several choices for various shapes of the virtual glass box, as well as enabling a user to specify a unique shape for the virtual glass box. Enabling the virtual glass box to take on shapes other than a rectangular parallelepiped accommodates the display of 2D auxiliary views, for example.

The virtual glass box representation of a model also allows the user to convert 2D views of an object into a 3D model. The 2D views are transformed onto the sides of the virtual glass box and serve as sketches of a 3D model thereby providing a mechanism that gives the user insight into the 3D spatial composition of the model. While the 2D views are being transformed onto the sides of the virtual glass box, the present invention can fold each 2D view in an animated fashion to position the 2D view on an appropriate side of the virtual glass box.

Implementations of the present invention provide an automated 2D to 3D data conversion process that allows an engineer to import one or more 2D views of a model and create a 3D model based on geometric features (e.g., fillets, extrusions, and holes), represented in the 2D data. The 2D to 3D data conversion process is a sequential, semi-automatic process that guides the engineer through the 3D geometry creation. The 3D geometry that is created may be wireframe geometry or solid geometry. Preferably, the data representing the 2D views is in a format enabling individual lines or other structural 2D entities to be selected as individual objects, such as the DWF format that enables the selection of lines, arcs, and points after importation. 2D objects in one view may then be associated with corresponding objects in other 2D views to derive additional spatial and geometric information about the 3D model (e.g., computations of shape, placement, and component dimensions).

A semi-automatic (i.e., a user-interactive approach) conversion approach helps engineers to convert 2D data that represent 3D models into true 3D models without the additional cost of hiring a conversion service to convert the models. A semi-automatic approach gives an engineer an interactive role in the conversion process allowing the engineer to control the creation and accuracy of the 3D models thereby providing a higher level of success in converting 2D data into 3D data than a manual or fully automatic conversion process. Allowing the engineer to control the creation and accuracy of the 3D models not only lets the engineer determine which features and dimensions should be driven by particular 2D geometric entities, but also lets the engineer capture his or her design intent in the 3D model. The semi-automatic approach also provides engineers with an interactive learning tool and enables engineers to intervene in the model building process when desired or necessary.

The 2D to 3D data conversion process includes the importation of 2D data into a 3D software environment. To aid in the creation of 3D model features, the conversion process automatically may add constraints to the imported geometry. For example, logical constraints may be added to a line so the line remains vertical or horizontal, or parallel to another line. Furthermore, drawing dimensions in the 2D data may aid in the construction of 3D model features. For example, dimensions that are specified textually in the 2D data are converted from the textual representation to actual measurements (e.g., by using automatic character recognition software or using the numerical value included in the software object that defines the dimension). The actual measurements may then be used to create a sketch in 3D space, which may serve as the basis of a cut extrusion, boss extrusion, revolve cut, revolve boss, loft, or other operation used to create a part. Actual measurements may also be used to define the depth of an extrusion. In addition, line fonts (i.e., line display characteristics such as hidden or dashed lines) specified in the 2D data may be mapped to different line fonts to better identify hidden lines and construction lines.

Conversion between 2D data and 3D data can be aided by a 2D-to-3D folding tool. The 2D-to 3D folding tool is an automated process for constructing 3D models from 2D data. The 2D-to-3D folding tool analyzes the 2D data that represents the 2D views and spatially arranges each one of the 2D views in the 3D modeling space. A virtual glass box representation of a 3D object is constructed when the folding tool spatially arranges a set of 2D views into a configuration, such as a rectangular parallelepiped configuration. The 2D views, arranged as the sides of the virtual glass box, can be further manipulated to create a 3D model from the original 2D data.

Generally, an engineer uses the 2D-to-3D folding tool after importing 2D data that specifies one or more views of a 3D model into the CAD system. The engineer needs to specify which view represents which side or orientation of the 3D model.

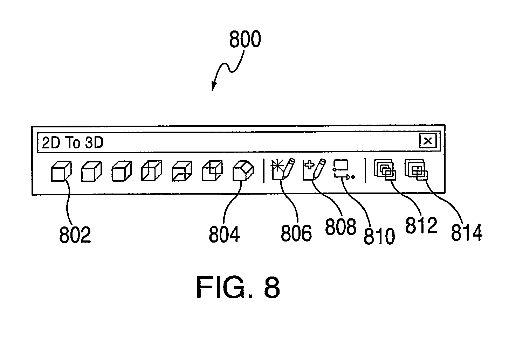

As shown in FIG. 8, one implementation of the present invention may display a toolbar 800 to indicate an orientation for a 2D view. The toolbar 800 contains buttons for specifying whether a view is a front, back, left, right, top, bottom, or auxiliary view. The engineer selects the 2D view, for example by selecting geometry in a 2D view, and then selects an orientation by pressing a button in the toolbar 800 (e.g. front view button 802 or auxiliary button 804). The folding tool then automatically creates a plane in 3D space as determined by the button selected for orientation. The 2D view geometry is then transformed such that the geometry lies on the plane. This process can be repeated to properly position multiple views of the model onto appropriate planes relative to one another. The views may be positioned as any standard view (i.e., front, back, left, right, bottom, and top), as well as auxiliary views (i.e., views that are not parallel to the principal X, Y, and Z axes) and section views. Auxiliary views may be positioned by specifying a plane on which the auxiliary view will be projected by specifying one or more additional entities (e.g., one or more segments from another 2D view) to enable orientation and positional reference. Section views may be oriented as any standard view or an auxiliary view.

The toolbar 800 may contain buttons for performing other functions in addition to functions that orient a view in 3D space. The toolbar 800 includes an extract sketch button 806, a repair sketch button 808, an align sketch button 810, a boss extrude button 812, and cut extrude button 814. The functions initiated after pressing one of the buttons 806-814 will later be discussed.

Referring once again to FIG. 3, a window 240 contains a 2D drawing 303 of a part after the drawing 303 has been imported into a 3D modeling system. The 2D drawing 303 consists of four 2D views 304-310. The four views depict the top of the part 304, the front side of the part 306, the right side of the part 308, and an auxiliary view of the part 310. The auxiliary view is a view that does not correspond to one of the six sides of a rectangular virtual glass box. To form one 3D view of the part, the four 2D views 304-310 are positioned with respect to one another in 3D space. The engineer indicates which side of a glass box is represented by each of the three views 304, 306, 308 displayed in the window 240. The engineer must also orient the auxiliary view 310 in 3D space. As previously discussed, to position a view, the view may be selected and a button in the toolbar that represents one of the six sides of the 3D model or represents an auxiliary view may be selected. After the engineer indicates which orthographic side is represented by a view or whether the view represents an auxiliary view, the view is mapped into 3D space and moves in an animated fashion to that orientation. In one implementation, the engineer must specify the front view first to define a first plane from which all other planes may be easily defined.

Mapping each view into 3D space may occur immediately after each view is selected and the orientation is indicated. Thus, each view may be positioned independently in an animated fashion. Alternatively, all indicated views may be positioned simultaneously in an animated fashion. Additionally, the engineer may control the speed of the animated movement of the views into 3D space. In some implementations, the positioning of views may be automated using parametric data interrelating features of different views or by user-selection of specific features. For example, if a first view contains a segment tagged with the identifier "A123," and a second view contains a segment tagged with the same identifier "A123," the modeling system will recognize that the two segments are a common edge of the modeled object. In some implementations, if data (e.g., parametric data) is unavailable to automatically relate views, an engineer may be able to select a segment in the first view and a corresponding segment in a second view and then provide input to the CAD system to associate the segments in the different views, thus enabling the CAD system to automatically position the views with respect to each other. In general, as more features are related (e.g., parametrically related or user related), the ability for the CAD system to match features in different views, interrelate the views, and derive geometry of the 3D object improves.

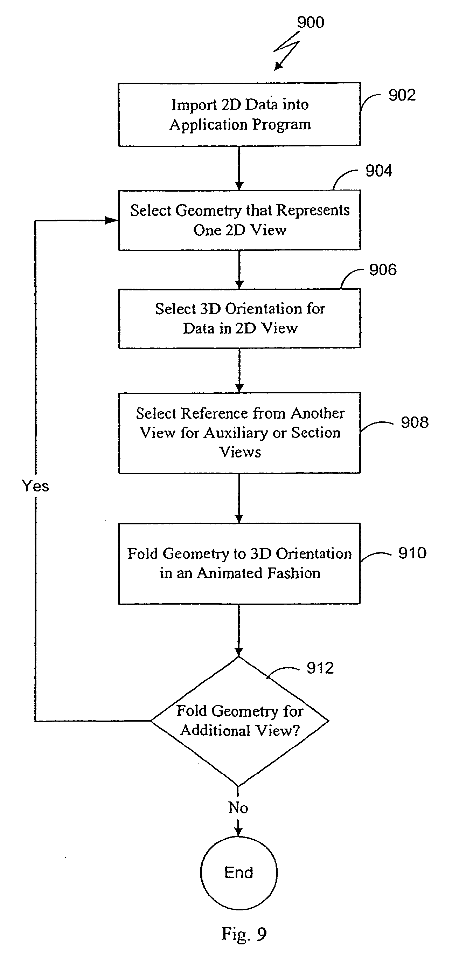

FIG. 9 is a flowchart of one implementation of a 2D-to-3D folding process. First the 2D data is imported into an application program (step 902). The engineer then selects the geometry that represents one 2D view (step 904). A 3D orientation for the data in the 2D view is then selected (step 906), for example by selecting a user interface button that pictorially highlights the orientation, such as front view button 802 or auxiliary button 804 shown in FIG. 8. The 3D orientation may be one of the six standard orthographic views, an auxiliary view, or a section view. The 3D orientation that was selected specifies the direction that the geometry will be folded. Folding may be achieved by applying a transformation that rotates, and possibly translates, the 2D view to the 3D orientation. For section or auxiliary views, the engineer selects a reference from another view to indicate the section line or to indicate a plane to which the auxiliary view will be parallel (step 908). The geometry may then be folded to the 3D orientation, which may occur in an animated fashion (step 910). Steps 904-910 are repeated to fold geometry for an additional view, if the process 900 determines that additional views are to be folded (step 912).

Folding the views into 3D space takes place after each view is selected and the orientation indicated (step 910), or after all views are selected and the orientations indicated depending on the implementation or a user's preference (i.e., step 910 may take place after step 912). The animation speed used to visualize the folding can be adjusted to provide feedback to the user with regards to the spatial relationship between a 2D representation of a model and a 3D representation of the model. For example, the user may control the setting of a parameter that in turn controls the speed of the animation. Different speed levels in terms of total animation time may be about one second, about three seconds, or about five seconds.

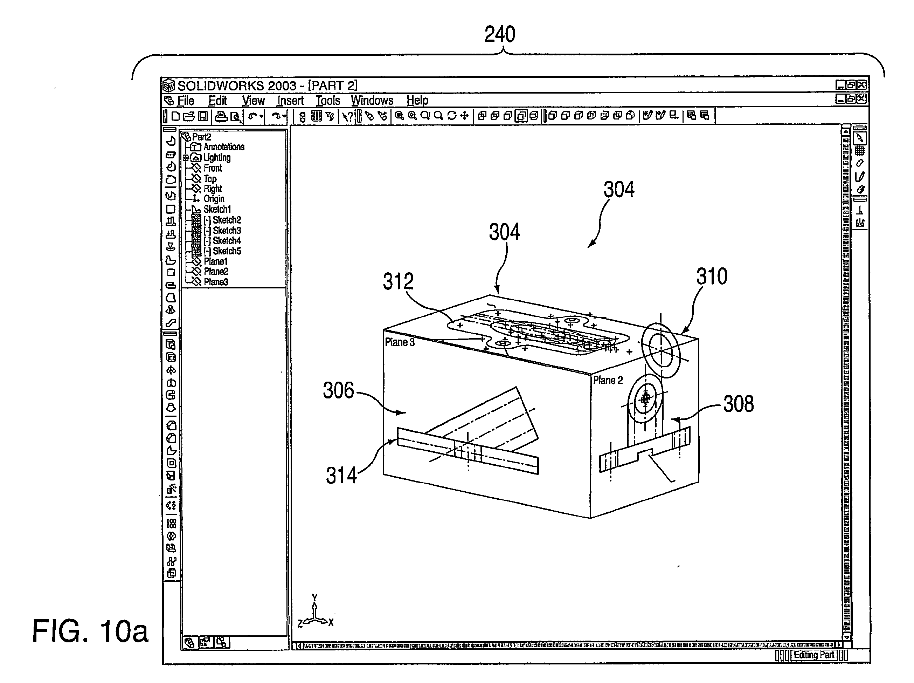

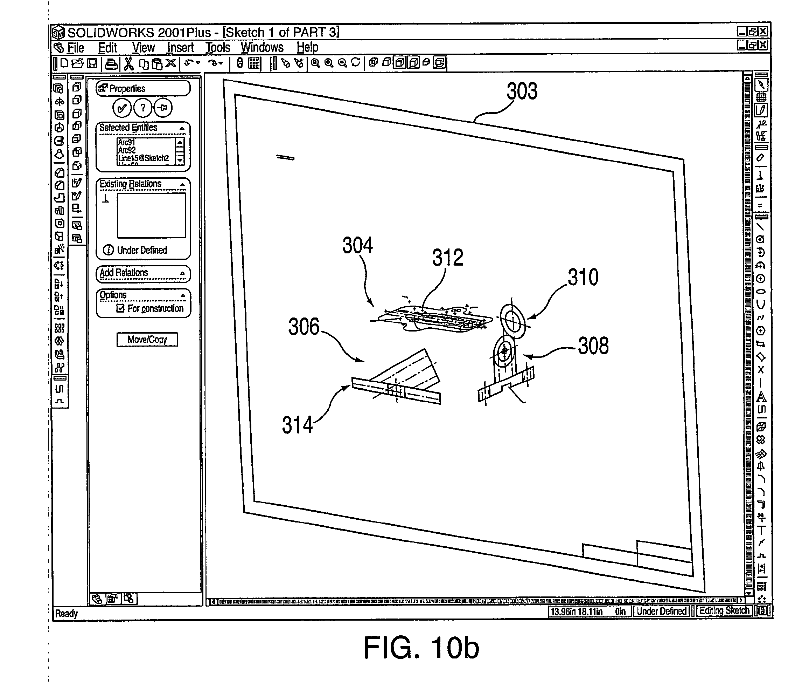

FIGS. 10a and 10b show the window 240 after the four views 304-310 have been mapped to 3D space with and without, respectively, the sides of the virtual glass box shaded. In FIG. 10b, the drawing 303 has been rotated to clearly display the 3D positions of the views to the viewer. When the views are positioned in 3D space, the views do not touch one another to aid the engineer in visualizing the spatial representations of the 2D views relative to one another in 3D space. The engineer may then construct a 3D model from the 2D views oriented in 3D space. The 2D views oriented in 3D space are sketches of the 3D model with which the engineer may interact. A sketch as used herein is a collection of 2D geometry (such as curves, lines, and arcs) that lies on a plane and constraints of the 2D geometry (such as parallel, tangent, and linear distance constraints). The engineer may use any geometric entity displayed in a sketch to define the 3D model. For example, the engineer may create the base of the 3D part 242 shown in FIG. 2 by extruding the top contour 312 in a downward direction for a given distance. To accomplish this, the engineer may select a boss extrusion command from the user interface (such as boss extrude button 812 shown in FIG. 8), select the contour 312 from the top side of the part 304, and select the lower segment 314 of the front side of the part 306 to specify the depth of the extrusion. The modeling system then extrudes the contour 312 a distance equal to the distance to the lower segment 314. To create a cylindrical boss, the engineer may select a boss extrusion command from the user interface (such as boss extrude button 812 shown in FIG. 8), the sketch of the auxiliary view 310, then the top face of the 3D feature created by extruding the top contour 312.

FIG. 11 shows the window 240 containing the 3D model 242 as constructed using the four surrounding 2D views 304-310. The image of the 3D model and 2D projections shown in FIG. 11 is a virtual glass box representation that includes an auxiliary projection 310 and does not include the bottom, back, and right 2D views.

In addition to the folding tool, the present invention provides other conversion tools for use in controlling the 2D to 3D conversion process. The conversion tools include an alignment tool to align the geometry in 3D space, a repair tool for cleaning up the geometry (e.g., to eliminate gaps, collect small line segments into a single entity, and resolve overlapping geometry), and an extract sketch tool for subdividing the geometry into useful subsets for the creation of 3D features, in addition to tools that extrude a profile for creating solid features from 2D sketches or wireframe geometry subsets.

The particular functions that may be performed in an implementation may vary depending on the format of the 2D data. For example, 2D data containing annotations that identify the size of particular features can be used to drive the creation of corresponding features of the 3D model, for instance by automatically setting the size of corresponding features. On the other hand, if the size of a feature cannot be derived from the 2D data, the engineer may need to manually enter the size. A 2D data format in which meta-data (such as an annotation) is parametrically attached to the data-representing feature (e.g., to vector data representing an edge of a surface) may facilitate extraction of useful data about the feature.

The alignment tool aids the engineer in creating 3D features. The alignment tool is generally used after two or more 2D views have been folded into 3D space, thereby becoming sketches that may be used to construct a 3D model. The alignment tool aligns two or more selected sketches before the engineer creates a feature. A user interface button, such as the align sketch button 810, may provide user access to the alignment tool. In one implementation, the user selects the align sketch button 810 then selects two sketches. The first sketch selected moves to align with the sketch selected second. Alignment may be controlled by selecting common segments in different views and then commanding the CAD system to position the common segments with respect to one another and with respect to the sides of the virtual glass box on which the segments are projected.

The repair tool enables the engineer to repair a sketch being used to construct a 3D model. The repair tool may be used to remove gaps, collect small line segments into a single entity, and resolve overlapping geometry. Repairing a sketch can often correct errors that may cause problems when a feature is created in a 3D model. For example, some extrusion operations only operate on closed profiles. Although, some operations (e.g., boss extrude and cut extrude) may repair sketches automatically when errors are detected, some errors may have to be fixed after being detected by the engineer. When a situation that requires repair is detected, a warning message is displayed in a dialog that states the possible problem and offers to repair the sketch automatically. In response, the engineer may simply press the OK button in the dialog to indicate that the repair should be made. The engineer may also repair sketches when he or she notices a problem. The engineer may simply choose the repair tool from the user interface, for example by selecting a repair sketch button 808 shown in FIG. 8, and indicate what geometry needs to be repaired.

The extract sketch tool allows the engineer to segregate specific elements of a sketch. One reason that an engineer may want to segregate specific elements is that only specific elements may be required to create a feature in the 3D model (e.g., contour 312 in FIGS. 10a and 10B used to create the base for the part). Furthermore, once specific elements of a sketch are segregated, those elements may be modified before a feature is created. A user interface button, such as the extract sketch button 806 shown in FIG. 8 may provide user access to the extract sketch tool.

Tools are provided to extrude a profile to create a 3D object. Extrusion tools includes a boss extrude tool, which adds material to the part, and a cut extrude tool, which subtracts material from the part. User interface buttons, such as the boss extrude button 812 and cut extrude button 814 may provide user access to the boss extrude and cut extrude tools, respectively.

Other methods used to construct a 3D object from a 2D sketch include sweeping a profile and revolving a profile. After identifying a profile, a sweep operation moves the profile along a path. To specify a path, an engineer may select or create a spline on a side of the virtual glass box perpendicular to the profile to be swept. A revolve operation rotates a profile about an axes, which may be specified by selecting a point on a side of the virtual glass box that is perpendicular to the side on which the profile is defined. The point represents the tip of an axis around which the profile may be revolved. Generally, once the 2D views become sketches spatially positioned in 3D space, any commands available in a CAD system that creates a 3D object from a 2D object may be used to construct a 3D model.

The present invention allows an engineer to utilize various techniques to select geometry. A box selection technique may be used whereby the engineer draws a square around the desired geometry by dragging the cursor from a first point to a second point. Another selection technique enables a single entity, such as a segment, to be selected with the result that only the single entity is selected.

Yet another selection technique that is particularly useful for rapidly selecting connected entities, referred to herein as a chain selection, enables a user to select a number of connected segments. Chain selection may be used to delete a set of connected entities, select a contour to specify a profile, or perform other functions with a set of connected entities may need to be selected. The chain selection technique discovers the endpoints of a selected segment. All sketch entities are then analyzed to ascertain whether any endpoints of other sketch entities are the same as that of the selected segment. A sketched entity having the same endpoint also becomes a member of the collective selection. Those sketch entities that are not members are analyzed once again to ascertain whether any endpoints of other sketch entities are the same as the new member, and if so, those other sketch entities also become members of the collective selection. The chain selection process continues until it is known that all sketched entities in the collection do not share a common endpoint with any sketch entities outside the collection.

Once an engineer has a 3D model, whether by constructing the model from scratch or importing 2D data, interacting with the model in 2D and in 3D simultaneously is useful. Simultaneous interaction with 2D and 3D representations of the model helps an engineer understand the relationship between the 2D views of the 3D model and between the 2D views and the 3D model. Moreover, section lines may be highlighted in one or more 2D views and within the 3D model. An engineer may also benefit by seeing the affects of traditional drawing operations not only in 2D, but simultaneously in 3D as well. Such traditional drawing operations may include specifying critical dimensions in a 2D view, the depth of a breakout view, and visibility regions that are defined and hidden behind a plane.

A breakout view is a 2D view of a model created by removing a portion of the model by a specified depth so that the user can see what lays behind the portion that was removed. This operation is generally performed in a 2D environment. In the 2D environment, the user does not always know how deep to make the cut because the arrangement of the model obscured in a conventional 2D view is unseen. The virtual glass box enables the user to more easily specify the break out view because the user can see the 3D object inside the virtual glass box and specify the depth of the cut, by for example, picking a point on a side of the virtual glass box that is perpendicular to the side on which the outline of the breakout view is sketched.

Visibility regions are portions of a model that an engineer wants to view. Often, regions are hidden by other assembly components or features of a part so an engineer may want to specify a region that should be visible. Using a virtual glass box, the regions may be easily defined in 3D by dynamically positioning a surface or plane to define the visibility region. The visibility region can then be projected onto a side of the virtual glass box.

Although the discussion has often referred to a rectangular parallelepiped as the shape of the virtual glass box, the virtual glass box can also assume other shapes, such as the shape of any polyhedron. A polyhedron can be defined by specifying a number of planes that together form the faces of the polyhedron. In some implementations, the projection may also be on surfaces of shapes other than polyhedron, such as a cylinder by way of non-limiting example. A cylindrical virtual glass box can accommodate sheet metal parts, and when unfolded, may help an engineer understand how the sheet metal needs to be cut to make the part. Thus many shapes may also be used and are embraced within the term "virtual glass box." Also, in some cases, the virtual glass box may not fully enclose the 3D model. For example, a surface of the virtual glass box may bisect the model because the virtual glass box may accommodate auxiliary or section views of the model.

In some implementations, the underlying data structures of the modeling software behave parametrically. For example, the geometry, display attributes, and annotations displayed as part of the model on the CRT 104 are updated as needed when a design engineer changes the model. Thus, if a vertex of an object is moved, an annotation having an arrow and a leader that points to the vertex of the object will move accordingly. Dimensions also behave parametrically. For example, a change in an underlying model may affect a dimension displayed in a 2D view on the CRT 104. The dimension will then be updated as needed, including the location of the dimension and the dimension value. A parametric modeling system (or parametric solid modeling system), ensures that desired features of a design are retained or appropriately modified as changes are made to other features.

In one implementation, a virtual glass box is represented in the modeling system as a solid model, which provides for topology and surface connectivity. Therefore, the virtual glass box has faces that share common edges.

In a solid modeling system, the modeled object can be constructed as an assembly of solid model components (i.e., parts and subassemblies). The solid model may have relationships that parametrically constrain the definitions of one or more components with respect to one another. If a parametrically constrained relationship exists between two components, changing a geometric feature of one component may change a geometric feature of the other component. For example, a component that is a fastener, such as a bolt, may be parametrically constrained by a hole feature in such a way that the diameter of the bolt increases or decreases respectively as the diameter of the hole increases or decreases.

The invention may be implemented in digital electronic circuitry, or in computer hardware, firmware, software, or in combinations thereof. Apparatus of the invention may be implemented in a computer program product tangibly embodied in a machine-readable storage device for execution by a programmable processor, and method steps of the invention may be performed by a programmable processor executing a program of instructions to perform functions of the invention by operating on input data and generating output. The invention may advantageously be implemented in one or more computer programs that are executable on a programmable system including at least one programmable processor coupled to receive data and instructions from, and to transmit data and instructions to, a data storage system, at least one input device, and at least one output device. Each computer program may be implemented in a high-level procedural or object-oriented programming language, or in assembly or machine language if desired; and in any case, the language may be a compiled or interpreted language. Suitable processors include, by way of example, both general and special purpose microprocessors. Generally, a processor will receive instructions and data from a read-only memory and/or a random access memory. Storage devices suitable for tangibly embodying computer program instructions and data include all forms of non-volatile memory, including by way of example semiconductor memory devices, such as EPROM, EEPROM, and flash memory devices; magnetic disks such as internal hard disks and removable disks; magneto-optical disks; and CD-ROM disks. Any of the foregoing may be supplemented by, or incorporated in, custom-designed ASICs (application-specific integrated circuits).

A number of embodiments of the present invention have been described. Nevertheless, it will be understood that various modifications may be made without departing from the spirit and scope of the invention. For example, the folding processes may occur without being animated. Implementations also may change the order in which operations are performed, such as, in FIG. 9, operation 904 may be performed immediately after operation 906 and then followed by operation 908, and operation 910 may be performed immediately after operation 912 so folding all views occurs simultaneously. Additional functionality may be added (e.g., functionality to detect edges and other features in a 2D bitmap image to allow curve extraction from imported 2D images). Depending on the needs of an implementation, particular operations described herein may be implemented as a combined operation, eliminated, added to, or otherwise rearranged. The invention disclosed herein may also be implemented in CAD software that addresses applications other than mechanical design. Accordingly, other embodiments are within the scope of the following claims. It is noted that, for clarity purposes, the term geometric "entities" has been used to refer to parts of a modeled object as displayed in a two-dimensional projection, while the term "features" has been used to refer to parts of the modeled object displayed as components of the three-dimensional model. It follows then that there is a direct correspondence between geometric "entities" of the two-dimensional representation and "features" of a three dimensional model.

## Claims

1. A computer-implemented method for the modeling of real-world objects, the method comprising:
- importing into a modeling system a plurality of two-dimensional representations of a three- dimensional object, the plurality of two-dimensional representations comprising projections of the three-dimensional object as viewed on different planes positioned in three-dimensional space;
- receiving input from a user to spatially arrange the plurality of two-dimensional representations on a plurality of virtual surfaces that are positioned in a three-dimensional modeling space, said virtual surfaces being positioned to correspond to surfaces on which projections of a three-dimensional model under construction by the user are rendered;
- interactively constructing the three-dimensional model of the three-dimensional object based on user-selection and manipulation of entities of the two-dimensional representations, said entities being components of the two-dimensional representations displayed on said virtual surfaces; and
- displaying the plurality of two-dimensional representations and the three-dimensional model simultaneously in said three dimensional modeling space.

2. The method of claim 1 wherein constructing based on the two-dimensional representations comprises : automatically constructing a component of the three-dimensional model comprising a first and a second geometric characteristic, the first characteristic being determined from a first entity selected from one of the two-dimensional representations, and the second characteristic being determined from a second entity selected from one of the two- dimensional representations.

3. The method of claim 2 wherein the first characteristic is a profile determined from a first sketch represented in a first one of the two-dimensional representations and the second characteristic is a depth of the profile determined from a segment represented in a second one of the two-dimensional representations.

4. The method of claim 3 wherein the depth is determined from a segment represented in the two-dimensional representations as a hidden segment.

5. The method of claim 2 wherein the first characteristic is a measurement determined based on a text label in a two-dimensional representation.

6. The method of claim 3 wherein constructing the component comprises extruding the profile determined from the first sketch to a depth determined from the segment.

7. The method of claim 1 wherein said virtual surfaces comprise virtual glass box surfaces enclosing an area in the three dimensional modeling space in which the three-dimensional model is under construction.

8. The method of claim 7 wherein each of the virtual surfaces comprises a planar surface.

9. The method of claim 8 wherein the plurality of planar surfaces form a polyhedron.

10. The method of claim 9 wherein the polyhedron is a rectangular parallelepiped.

11. The method of claim 8 wherein the plurality of two-dimensional representations comprises an auxiliary view, the auxiliary view comprising a projection other than on one of the plurality of surfaces, and the input to spatially arrange the two-dimensional representations comprises input to orient an auxiliary planar surface with respect to the plurality of other virtual surfaces and to position the auxiliary view representation on the auxiliary planar surface.

12. The method of claim 8 wherein receiving input to spatially arrange the two-dimensional projections comprises receiving input to associate entities in different ones of the two- dimensional projections, and the method comprising spatially arranging the two-dimensional projections based on the associated entities.*

13. A computer-aided modeling system comprising:
a data storage device, a processor, an input device, and a display coupled to the processor, the data storage device comprising instructions to cause the processor to: import into a modeling system a plurality of two-dimensional representations of a three- dimensional object, the plurality of two-dimensional representations comprising projections of the three-dimensional object as viewed on different planes positioned in three-dimensional space;
**-** receive input from a user to spatially arrange the plurality of two-dimensional representations on a plurality of virtual surfaces that are positioned in a three-dimensional modeling space, said virtual surfaces being positioned to correspond to surfaces on which projections of a three-dimensional model under construction by the user are rendered;
- interactively construct the three-dimensional model of the three-dimensional object based on user-selection and manipulation of entities of the two-dimensional representations, said entities being components of the two-dimensional representations displayed on said virtual surfaces; and
- display the plurality of two-dimensional representations and the three-dimensional model simultaneously in said three dimensional modeling space..

## Patentansprüche

1. Computerimplementiertes Verfahren zur Modellierung von Realwelt-Objekten, wobei das Verfahren umfasst:
- das Importieren einer Vielzahl von zweidimensionalen Darstellungen eines dreidimensionalen Objekts in ein Modelliersystem, wobei die Vielzahl von zweidimensionalen Darstellungen Projektionen des dreidimensionalen Objekts umfasst, von verschiedenen Ebenen im dreidimensionalen Raum aus gesehen;
- das Empfangen einer Eingabe von einem Benutzer, um die Vielzahl von zweidimensionalen Darstellungen auf einer Vielzahl von virtuellen Flächen anzuordnen, die in einem dreidimensionalen Modellierraum liegen, wobei diese virtuellen Flächen positioniert sind, um Flächen zu entsprechen, auf denen Projektionen eines dreidimensionalen Modells wiedergegeben werden, das vom Benutzer konstruiert wird;
- das interaktive Konstruieren des dreidimensionalen Modells des dreidimensionalen Objekts auf der Basis der Benutzerauswahl und der Manipulation von Einheiten der zweidimensionalen Darstellungen, wobei diese Einheiten Komponenten der zweidimensionalen Darstellungen sind, die auf den virtuellen Flächen angezeigt werden; und
- das gleichzeitige Anzeigen der Vielzahl von zweidimensionalen Darstellungen und des dreidimensionalen Modells im dreidimensionalen Modellierraum.

2. Verfahren nach Anspruch 1, wobei das Konstruieren auf der Basis der zweidimensionalen Darstellungen umfasst:
das automatische Konstruieren einer Komponente des dreidimensionalen Modells, umfassend eine erste und eine zweite geometrische Charakteristik, wobei die erste Charakteristik anhand einer ersten Einheit bestimmt wird, die aus einer der zweidimensionalen Darstellungen gewählt wird, und die zweite Charakteristik anhand einer zweiten Einheit bestimmt wird, die aus einer der zweidimensionalen Darstellungen gewählt wird.

3. Verfahren nach Anspruch 2, wobei die erste Charakteristik ein Profil ist, das anhand eines ersten Umrisses bestimmt wird, der in einer ersten der zweidimensionalen Darstellungen dargestellt wird, und die zweite Charakteristik eine Tiefe des Profils ist, die anhand eines Segments bestimmt wird, das in einer zweiten der zweidimensionalen Darstellungen dargestellt wird.

4. Verfahren nach Anspruch 3, wobei die Tiefe anhand eines Segments bestimmt wird, das in den zweidimensionalen Darstellungen als verstecktes Segment dargestellt wird.

5. Verfahren nach Anspruch 2, wobei die erste Charakteristik eine Messung ist, die auf der Basis einer Textfelds in einer zweidimensionalen Darstellung bestimmt wird.

6. Verfahren nach Anspruch 3, wobei das Konstruieren der Komponente das Extrudieren des anhand der ersten Umrisses bestimmten Profils auf eine anhand des Segments bestimmte Tiefe umfasst.

7. Verfahren nach Anspruch 1, wobei die virtuellen Flächen virtuelle Glasboxflächen umfassen, die einen Bereich im dreidimensionalen Modellierraum umschließen,
in welchem das dreidimensionale Modell konstruiert wird.

8. Verfahren nach Anspruch 7, wobei jede der virtuellen Flächen eine Planfläche aufweist.

9. Verfahren nach Anspruch 8, wobei die Vielzahl von Planflächen ein Polyeder formen.

10. Verfahren nach Anspruch 9, wobei das Polyeder ein rechteckiges Parallelepiped ist.

11. Verfahren nach Anspruch 8, wobei die Vielzahl von zweidimensionalen Darstellungen eine Hilfsansicht umfasst, wobei die Hilfsansicht eine andere Projektion als auf einer von der Vielzahl von Flächen aufweist und die Eingabe zur räumlichen Anordnung der zweidimensionalen Darstellungen eine Eingabe umfasst, um eine Hilfsplanfläche in Bezug auf die Vielzahl von anderen virtuellen Flächen zu orientieren und die Hilfsansicht-Darstellung auf der Hilfsplanfläche zu positionieren.

12. Verfahren nach Anspruch 8, wobei das Empfangen der Eingabe zur räumlichen Anordnung der zweidimensionalen Projektionen das Empfangen einer Eingabe umfasst, um Einheiten in verschiedenen der zweidimensionalen Darstellungen zu verknüpfen, und das Verfahren das räumliche Anordnen der zweidimensionalen Projektionen auf der Basis der verknüpften Einheiten umfasst.*

13. Computergestütztes Modelliersystem, umfassend:
ein Datenspeichergerät, einen Prozessor, ein Eingabegerät und eine mit dem Prozessor gekoppelte Anzeige, wobei das Datenspeichergerät Anweisungen enthält, um zu veranlassen, dass der Prozessor:
- eine Vielzahl von zweidimensionalen Darstellungen eines dreidimensionalen Objekts in ein Modelliersystem importiert, wobei die Vielzahl von zweidimensionalen Darstellungen Projektionen des dreidimensionalen Objekts umfasst, von verschiedenen Ebenen im dreidimensionalen Raum aus gesehen;
- die Eingabe eines Benutzers empfängt, um die Vielzahl von zweidimensionalen Darstellungen auf einer Vielzahl von virtuellen Flächen anzuordnen, die in einem dreidimensionalen Modellierraum liegen, wobei diese virtuellen Flächen positioniert sind, um Flächen zu entsprechen, auf welchen Projektionen eines dreidimensionalen Modells wiedergegeben werden, das vom Benutzer konstruiert wird;
- das dreidimensionale Modell des dreidimensionalen Objekts auf der Basis der Benutzerauswahl und der Manipulation von Einheiten der zweidimensionalen Darstellungen auf interaktive Weise konstruiert, wobei diese Einheiten Komponenten der zweidimensionalen Darstellungen sind, die auf den virtuellen Flächen angezeigt werden; und
- die Vielzahl von zweidimensionalen Darstellungen und das dreidimensionale Modell gleichzeitig im dreidimensionalen Modellierraum anzeigt.

## Revendications

1. Un procédé mis en oeuvre par ordinateur pour la modélisation d'objets du monde réel, le procédé comprenant:
- l'importation dans un système de modélisation d'une pluralité de représentations en deux dimensions d'un objet tridimensionnel, la pluralité de représentations en deux dimensions comprenant des projections de l'objet tridimensionnel telles qu'il est vu selon différents plans positionnés dans un espace tridimensionnel;
- la réception d'entrée d'un utilisateur pour agencer spatialement la pluralité de représentations en deux dimensions sur une pluralité de surfaces virtuelles qui sont positionnées dans un espace de modélisation tridimensionnel, lesdites surfaces virtuelles étant positionnées pour correspondre à des surfaces sur lesquelles les projections du modèle tridimensionnel en construction par l'utilisateur sont rendues;
- la construction interactive du modèle tridimensionnel de l'objet tridimensionnel sur la base d'une sélection de l'utilisateur et la manipulation d'entités des représentations en deux dimensions, lesdites entités étant des composants des représentations en deux dimensions affichées sur lesdites surfaces virtuelles; et
- l'affichage la pluralité de représentations en deux dimensions et du modèle tridimensionnel simultanément dans ledit espace de modélisation tridimensionnel.

2. Le procédé selon la revendication 1, dans lequel la construction basée sur les représentations en deux dimensions comprend : la construction automatique d'un composant du modèle tridimensionnel comprenant une première et une deuxième caractéristique géométrique, la première caractéristique étant déterminée à partir d'une première entité sélectionnée à partir d'une des représentations en deux dimensions, et la deuxième caractéristique étant déterminée à partir d'une deuxième entité sélectionnée à partir d'une des représentations en deux dimensions.

3. Le procédé selon la revendication 2, dans lequel la première caractéristique est un profil déterminée à partir d'un premier dessin représenté dans une première représentation des représentations en deux dimensions et la deuxième caractéristique étant une profondeur du profil déterminée à partir d'un segment représenté dans une deuxième représentation des représentations en deux dimensions.

4. Le procédé selon la revendication 3, dans lequel la profondeur est déterminée à partir d'un segment représenté dans les représentations à deux dimensions en tant que segment caché.

5. Le procédé selon la revendication 2, dans lequel la première caractéristique est une mesure déterminée sur la base d'une étiquette de texte dans une représentation à deux dimensions.

6. Le procédé selon la revendication 3, dans lequel la construction de composant comprend l'extrusion du profil déterminé à partir du premier dessin à une profondeur déterminée à partir du segment.

7. Le procédé selon la revendication 1, dans lequel lesdites surfaces virtuelles comprennent des surfaces virtuelle d'une boîte en verre entourant la zone dans l'espace de modélisation tridimensionnel dans lequel le modèle tridimensionnel est en construction.

8. Le procédé selon la revendication 7, dans lequel chacune des surfaces virtuelles comporte une surface plane.

9. Le procédé selon la revendication 8, dans lequel la pluralité de surfaces planes formes un polyèdre.

10. Le procédé selon la revendication 9, dans lequel le polyèdre est un parallélépipède rectangle.

11. Le procédé selon la revendication 8, dans lequel la pluralité de représentation en deux dimensions comprend une vue subsidiaire, la vue subsidiaire comprenant une projection autre qu'une sur la pluralité des surfaces, et que l'entrée pour agencer spatialement les représentations en deux dimensions comprend une entrée pour orienter une surface subsidiaire plane par rapport à la pluralité d'autre surface virtuelle et pour positionner la représentation de la vue subsidiaire sur une surface subsidiaire plane.

12. Le procédé selon la revendication 8, dans lequel la réception de l'entrée pour agencer spatialement les représentations en deux dimensions comprend la réception d'entrées pour associer les entités en entités différentes des projections en deux dimensions, et la méthode comprend l'agencement spatial des projections en deux dimensions sur la base des entités associées.

13. Un système de modélisation assisté par ordinateur, comprenant:
un dispositif de mémorisation des données, un processeur, un dispositif d'entrées, et un afficheur couplé au processeur, le dispositif de mémorisation des données comprenant des instructions amenant le processeur à mettre en oeuvre :
- l'importation dans un système de modélisation d'une pluralité de représentations en deux dimensions d'un objet tridimensionnel, la pluralité de représentations en deux dimensions comprenant des projections de l'objet tridimensionnel telles qu'il est vu selon différents plans positionnés dans un espace tridimensionnel;
- la réception d'entrée d'un utilisateur pour agencer spatialement la pluralité de représentations en deux dimensions sur une pluralité de surfaces virtuelles qui sont positionnées dans un espace de modélisation tridimensionnel, lesdites surfaces virtuelles étant positionnées pour correspondre à des surfaces sur lesquelles les projections du modèle tridimensionnel en construction par l'utilisateur sont rendues;
- la construction interactive du modèle tridimensionnel de l'objet tridimensionnel sur la base d'une sélection de l'utilisateur et la manipulation d'entités des représentations en deux dimensions, lesdites entités étant des composants des représentations en deux dimensions affichées sur lesdites surfaces virtuelles; et
- l'affichage la pluralité de représentations en deux dimensions et du modèle tridimensionnel simultanément dans ledit espace de modélisation tridimensionnel.
